# EUROPEAN PATENT APPLICATION

(11) **EP 2 042 546 A1**
(43) Date of publication of application: **01.04.2009**
(21) Application number: 08253057.7
(22) Date of filing: 18.09.2008
(51) Int. Cl.: C08K 3/00, C08K 13/00, C08K 9/06, H01B 3/00

(54) **Paste composition, insulating film, multilyer interconnection structure, printed-circuit board, image display device, and manufacturing method of paste composition**

(30) Priority: 21.09.2007 JP 2007245527; 24.07.2008 JP 2008191349
(71) Applicant: Ricoh Company, Ltd., Tokyo 143-8555 (JP)
(72) Inventor: Mayuka, Araumi, Ohta-ku Tokyo (JP)
(74) Representative: Benson, John Everett

(57) **Abstract**

A disclosed paste composition includes a filler and a resin. The filler includes insulating filling material particles made of at least one of silica and titania, and insulating particles made of at least one of silica and titania whose surfaces have been hydrophobic treated, or insulating particles having at least their surfaces made of a material other than silica or titania. The volume of the insulating filling material particles is more than or equal to 20% of the total volume of the filler and less than or equal to 80% of the total volume of the filler.

## Description

### BACKGROUND OF THE INVENTION

### 1. Field of the Invention

The present invention relates to a paste composition, an insulating film, a multilayer interconnection structure, a printed-circuit board, an image display device, and a manufacturing method of the paste composition.

### 2. Description of the Related Art

In recent years and continuing, in order to respond to demands for higher performance and smaller/thinner devices, electronic equipment such as circuit boards and semiconductor devices is rapidly being developed into integrated circuits of even larger scale having multilayer interconnection structures. Usually, an electronic component having a multilayer interconnection structure has an insulating portion such as an insulating film or a sealing layer for insulating a conductive portion made of a metal material and a semiconductor. An interlayer insulating film located between conductive portions has through holes formed according to need, which electrically connects the conductive portions (hereinafter, such conductive through holes are also referred to as "via holes").

Conventionally, silicon dioxide films have been used as materials for the interlayer insulating film. Recently, organic insulating films are being widely used as an insulating material having a lower relative dielectric constant than silicon dioxide films. A photolithography method has been used to form through holes in organic insulating films. However, this method includes many manufacturing processes, which is disadvantageous in terms of cost.

As a method to form patterns in an organic insulating film, there is a screen printing method as an alternative method to the photolithography method. The screen printing method is performed by: coating, with an emulsion, a non-printing region to which ink is not transferred; putting ink on a screen mesh having a print pattern (screen printing plate or simply referred to as plate), which ink is to become the organic insulating film; and sliding a squeegee along the plate. Accordingly, the ink is only transferred to the printing region in the printing operation. With this method, the number of processes can be reduced, and the usage efficiency of the material can be increased. Thus, with the screen printing method, fine patterns can be formed by a simple method. Therefore, the screen printing method has been recently used for wiring processes of transistors, etc.

However, in the screen printing method, the ink is fluid immediately after printing is performed, and therefore the ink becomes flat with gravity, which may cause slight smudges. Therefore, a fine pattern formed by the screen printing method does not exactly match the pattern on the screen printing plate. Particularly, when forming an ink layer with microscopic through holes in the pattern, immediately after the printing operation, the ink around the through holes is highly likely to flow into the through holes and fill the through holes. Thus, in order to reliably form through holes in the ink layer, it is considered that the minimum diameter of each through hole is to be around 300 µm.

Methods described in patent documents 1 and 2 are known techniques for forming fine patterns with ink. The conventional technique disclosed in patent document 1 appears to be the most relevant to the present invention. The ink for forming fine patterns disclosed in patent document 1 is an insulating resin paste including superfine silica particles having an average particle diameter of 2 nm through 50 nm whose surfaces have been hydrophobic treated, a silica filler having an average particle diameter of 1 µm through 20 µm, and a liquid resin component.

Patent document 2 discloses a paste-like conductive material in which nano-sized metal particles and micron-sized metal particles are contacting each other. By using such a paste-like conductive material, a composite conductive material can be provided, having high conductivity and adhesiveness.

Patent document 3 pertains to a resin composition having good screen printing properties, and proposes a resin composition for screen printing, including polyamic acid resin or polyimide resin, spherical metallic oxide particles having an average particle diameter of 0.05 µm through 10 µm, and an organic solvent. By using this resin composition for screen printing, it is possible to mitigate problems of ink remaining in mesh openings, smudges, and bubbles remaining in the ink.
Patent Document 1: Japanese Patent No. 3189988
Patent Document 2: Japanese Laid-Open Patent Application No. 2006-339057
Patent Document 3: Japanese Laid-Open Patent Application No. 2007-016158

As described above, ink for printing fine patterns has been proposed. However, the insulating resin paste described in patent document 1 includes a filler having an average particle diameter of 1 µm through 20 µm, and 50 µm at maximum, which is difficult to apply to ink for forming microscopic through holes and fine patterns required to have a flatness in units of microns or less. Furthermore, only a dispenser method is described as the method of forming patterns, and therefore it is unknown as to whether this insulating resin paste is applicable to the screen printing method.

Moreover, it is logically unclear as to whether microscopic printing can be performed with the paste-like conductive material described in patent document 2. Furthermore, nothing is mentioned about the possibility of forming patterns serving as fine non-printing regions in the printing region, such as forming microscopic through holes in an ink layer for a pattern that is close to a solid pattern.

Patent document 3, which discloses the resin composition for screen printing, neither describes the extent of mitigating smudges nor the possibility of forming fine patterns. Therefore, the fineness of patterns that can be created with this resin composition is unclear.

As described above, no techniques have been established for providing an insulating paste composition with which various fine patterns can be printed. Specifically, there are no conventional techniques for printing microscopic through holes in a pattern by a screen printing method that can be performed with simple printing procedures and with reduced cost, or for providing an insulating film having fine patterns with microscopic through holes formed by the screen printing method.

### SUMMARY OF THE INVENTION

The present invention provides a paste composition, an insulating film, a multilayer interconnection structure, a printed-circuit board, an image display device, and a manufacturing method of the paste composition, in which one or more of the above-described disadvantages are eliminated.

A preferred embodiment of the present invention provides an insulating paste composition with which fine patterns can be printed by a screen printing method, a method of manufacturing the insulating paste composition, an insulating film in which fine patterns can be formed, a multilayer interconnection structure including this insulating film, a printed-circuit board including this multilayer interconnection structure, and an image display device including this printed-circuit board.

According to an aspect of the present invention, there is provided a paste composition including a filler including insulating filling material particles including at least one of silica and titania, and insulating particles including at least one of silica and titania whose surfaces have been hydrophobic treated, or insulating particles having at least their surfaces including a material other than silica or titania; and a resin.

According to one embodiment of the present invention, there are provided an insulating paste composition with which fine patterns can be printed by a screen printing method, a method of manufacturing the insulating paste composition, an insulating film in which fine patterns can be formed, a multilayer interconnection structure including this insulating film, a printed-circuit board including this multilayer interconnection structure, and an image display device including this printed-circuit board.

### BRIEF DESCRIPTION OF THE DRAWINGS

Other objects, features and advantages of the present invention will become more apparent from the following detailed description when read in conjunction with the accompanying drawings, in which:
FIG. 1 is a schematic diagram of a paste composition according to an embodiment of the present invention;
FIG. 2 is a schematic diagram of an insulating film according to an embodiment of the present invention;
FIG. 3 shows the relationship between a mixture ratio of a filler and a thixo index;
FIG. 4 illustrates a method of manufacturing the paste composition;
FIGS. 5A through 5C illustrate screen printing plates for forming through hole patterns;
FIG. 6 illustrates the minimum size of a through hole;
FIGS. 7A and 7B illustrate the screen printing plate used in practical examples 1 through 4 and comparative examples 1 through 3;
FIG. 8 illustrates the screen printing plate used in practical examples 5 through 9 and 11;
FIGS. 9A and 9B illustrate through holes formed in insulating films 9 through 13;
FIG. 10 is a sectional view of an example of a multilayer interconnection structure according to an embodiment of the present invention; and
FIG. 11 is a sectional view of an example of an image display device according to an embodiment of the present invention.

### DETAILED DESCRIPTION OF THE PREFERRED EMBODIMENTS

A description is given, with reference to the accompanying drawings, of an embodiment of the present invention.

The present invention is not limited to the specifically disclosed embodiment, and variations and modifications may be made without departing from the scope of the present invention.

A paste composition and an insulating film according to an embodiment of the present invention includes resin and a filler. The filler includes insulating filling material particles and insulating particles. The insulating filling material particles are made of at least silica and/or titania (hereinafter, simply referred to as "insulating filling material particles" unless otherwise specified). The insulating particles are silica and/or titania particles whose surfaces have been hydrophobic treated. The volume of the insulating filling material particles is more than or equal to 20% of the total volume of the filler and less than or equal to 80% of the total volume of the filler. Alternatively, the insulating particles have at least their surfaces made of a material other than silica or titania. With this paste composition, an insulating film having fine patterns can be provided, such as an insulating film having microscopic through holes in the patterns, by using a simple method such as the screen printing method.

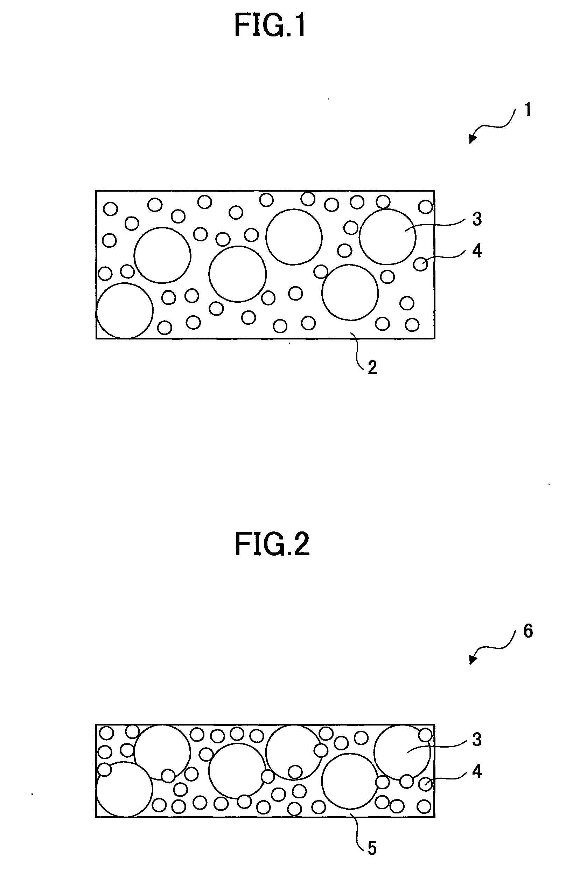

FIGS. 1 and 2 are schematic diagrams of a paste composition and an insulating film according to an embodiment of the present invention, respectively. Referring to FIG. 1, a paste composition 1 includes at least resin and a filler. The filler includes insulating particles 3 and insulating filling material particles 4. Usually, the resin is dissolved in a resin solvent 2; however, the resin can be provided as a curing resin precursor such as an ultraviolet curing resin precursor. The solvent in this paste composition 1 is dried, or energy such as ultraviolet rays are applied to cure the curing resin precursor in the paste composition 1, so that an insulating film 6 is obtained. As shown in FIG. 2, as the filler, the insulating particles 3 and the insulating filling material particles 4 are present in a resin 5 in the insulating film 6. In any case, the shape of the filler particles, the size proportions of the insulating particles 3 and the insulating filling material particles 4, and the mixture ratio of the materials can be appropriately adjusted according to need, as described in detail below.

The reason why the filler includes at least insulating particles and insulating filling material particles made of a different material from the insulating particles, is given as follows. That is, when fine patterns are formed by a printing method, the printing performance is largely affected by the physical qualities of the paste composition used as the ink. Particularly, in a screen printing method, the viscosity of the paste composition being used as the printing ink is extremely important. Primary examples of the viscosity that affects the printing performance are a thixotropic property and dynamic viscoelasticity.

A thixotropic property is a property in which the viscosity changes according to the shear rate applied to the paste composition. In screen printing, at the moment when the paste composition is transferred (printed) onto a substrate (in a dynamic state), the paste composition is preferably in a fluid state, and after the paste composition has been transferred (in a static state), the paste composition is preferably not fluid, the paste composition is preferably still. Therefore, the paste composition needs to have a thixotropic property. The paste composition will have the thixotropic property if it includes a filler. If the paste composition includes a filler, in a static state, the weak cohesive strength occurs due to the interaction between the filler particles, and therefore the viscosity increases. However, when the paste composition is stirred or oscillated, the paste composition becomes dynamic, and this cohesive strength is broken, so that the viscosity decreases. Therefore, when preparing a paste composition, it is necessary to adjust the type and content of the filler, so that an appropriate thixotropic property is exhibited for printing a desired pattern.

Dynamic viscoelasticity is an index indicating the balance between viscosity and elasticity when the paste composition receives stress. Viscosity is a property which makes an object deform or become fluid when force is applied. In a perfect viscous body, the speed of deformation increases in proportion to the stress. On the other hand, elasticity is a property which makes an object temporarily deform when force is applied, and restore its original shape when the force is removed. In a perfect elastic body, the amount of deformation increases in proportion to the stress. Generally, a paste material has properties of both viscosity and elasticity. The paste composition used for screen printing has viscosity, i.e., a property which makes an object deform or become fluid when force is applied, and therefore passes through a printing plate to be transferred onto a substrate. Subsequently, the paste composition can be leveled (flattened) by gravity. Furthermore, the paste composition has elasticity, i.e., the paste composition can be easily cut apart, and therefore the patterning can be done with good performance. Accordingly, in order to form fine patterns, the paste composition needs to be appropriately fluid as well as easy to cut apart.

The volume of the insulating filling material particles included in the filler is preferably more than or equal to 20% and less than or equal to 80% of the entire volume of the filler. When the amount of the insulting filling material particles is small, the paste composition will have high elasticity. In this case, the paste composition is unlikely to be leveled (flattened) after being passed through meshes of a screen printing plate and transferred (printed) on a printing substrate. As a result, the surface of the insulating layer may become uneven (bumpy). Conversely, when the amount of the insulting filling material is large, the paste composition will have high levels of viscosity, fluidity, and extendability. A paste composition having high fluidity and extendability is hard to cut apart, and is therefore inappropriate for forming fine patterns. The inventors of the present invention conducted a printing experiment by fabricating various paste compositions having different mixture ratios of the insulating particles and the insulating filling material particles. It was found that when the volume of the insulating filling material particles is more than or equal to 20% and less than or equal to 80% of the entire volume of the filler, fine patterns can be formed with good performance. Particularly good results were achieved when the volume of the insulating filling material particles is more than or equal to 40% and less than or equal to 70% of the entire volume of the filler.

For the above reasons, the paste composition according to an embodiment of the present invention includes a filler so that it has a thixotropic property. The filler includes insulating particles which mainly provide elasticity, and insulating filling material particles which mainly provide viscosity, so that the elasticity and viscosity are appropriately adjusted. Consequently, fine patterns with microscopic through holes can be printed, which has been difficult with conventional techniques.

The reason why silica and/or titania particles are appropriate for the insulating filling material particles is that these materials have high thickening effects. The silica and titania used in an embodiment of the present invention do not correspond to perfect compounds of SiO₂ and TiO₂, but are industrially-used silica and titania, which includes a small amount of impure substances and hydroxyl groups.

For example, if silica particles are dispersed in a liquid, the silanol groups (-Si-OH) on the surfaces will interact with each other via liquid molecules due to hydrogen bonding. Accordingly, the attracting force among the particles cause a thickening effect, so that the liquid becomes less fluid (i.e., the viscosity increases). Similarly, the hydrogen groups (-OH) on the surfaces will interact with each other, and therefore the titania particles also cause a thickening effect. The thickening effect can also be achieved with other inorganic materials. However, silica and titania particles have high-density silanol groups or hydrogen groups provided on their surfaces, and are therefore considered to have particularly high thickening effects.

As for silica, various kinds of synthetic silica particles can be used, such as fumed silica, colloidal silica, precipitated silica, crystalline silica, ground silica, and fused silica. Particularly, fused silica is preferable as it has superior electrical insulation properties and includes less impurities.

As for titania, various kinds of synthetic titania particles can be used, which are manufactured by methods such as a vapor-phase oxidation method or a hydrothermal synthesis method. The insulating filling material particles can be in any shape such as spheres, flakes, layers, or hollow, according to the purpose. However, spherical particles are preferable in terms of dispersiveness and printing properties of the paste composition.

In the paste composition according to an embodiment of the present invention, the average particle diameter of the insulating filling material particles included in the filler is preferably smaller than the average particle diameter of the insulating particles. As described above, the insulating particles are expected to mainly provide elasticity to the paste composition, and the insulating filling material particles are expected to mainly provide viscosity to the paste composition. In other words, if the paste composition only included the insulating filling material particles, the paste composition will only be fluid and extendable, which is inappropriate for printing. However, by adding insulating particles, the paste composition will become appropriately easy to cut, so that printing can be performed with good performance. Therefore, the insulating filling material particles are to have particle diameters which will increase the thickening effect (ability of increasing viscosity) of the paste composition, so that the viscosity of the paste composition can be effectively increased. The thickening property is proportionate to the surface area, and therefore the surface area per unit amount of the insulating filling material particles is preferably large, i.e., the particle diameters of the insulating filling material particles are preferably small. If the particle diameter of the insulating filling material particles is the same or larger than that of the insulating particles, the interaction between large insulating filling material particles will be strong. As a result, even if insulating particles are added to the paste composition, the ease in cutting the paste composition will not be enhanced very much, and therefore effects of the present invention are unlikely to be achieved. For the above reasons, the average particle diameter of the insulating filling material particles is preferably smaller than that of the insulating particles. More preferably, the average particle diameter of the insulating filling material particles is less than or equal to half that of the insulating particles.

In the paste composition according to an embodiment of the present invention, the average particle diameter of the insulating filling material particles included in the filler is preferably more than or equal to 20 nm and less than or equal to 1 µm. If the particle diameters of the insulating filling material particles are too small, it will be difficult to stably disperse the insulating filling material particles in the paste composition. Therefore, the average particle diameter is preferably at least more than or equal to 20 nm, more preferably more than or equal to 40 nm. Conversely, if the insulating filling material particles are too large, the formed insulating film may become heterogeneous, although this depends on the amount of the insulating filling material particles and the sizes of the insulating particles. Therefore, the average particle diameter is preferably less than or equal to 1 µm, more preferably less than or equal to 0.8 µm. Generally, there is a particle diameter distribution in materials being in the form of particles, and the filler used in an embodiment of the present invention is no exception. More preferably, to form a homogeneous insulating film, the particle diameter of the largest particle included in the filler is less than or equal to half the thickness of the insulating film to be formed. For example, if the thickness of the insulating film to be formed is 100 µm, the maximum particle diameter in the filler is preferably less than or equal to 50 µm; if the thickness of the insulating film to be formed is 60 µm, the maximum particle diameter in the filler is preferably less than or equal to 30 µm; if the thickness of the insulating film to be formed is 40 µm, the maximum particle diameter in the filler is preferably less than or equal to 20 µm; and if the thickness of the insulating film to be formed is 20 µm, the maximum particle diameter in the filler is preferably less than or equal to 10 µm.

The average particle diameter and the maximum particle diameter in the filler according to an embodiment of the present invention are measured by methods such as laser diffraction, laser diffraction scattering, and dynamic light scattering.

A conventionally known insulating filler can be used as the insulating particles used in an embodiment of the present invention, as long as they are insulating particles of silica and/or titania whose surfaces have been hydrophobic treated or insulating particles having at least their surfaces made of a material other than silica or titania. As to the quality of the material, either an inorganic material or an organic material can be used, as long as the material having insulating properties can be included as particles in the paste composition. In a practical situation, inorganic materials are more preferable, because the diameters and the shapes of the particles can be easily adjusted, and inorganic materials are more superior in terms of dispersiveness, thermal resistance, stability, and durability.

Examples of insulating particles are metallic oxide particles and metal hydroxide particles which are generally used in fields of electronic/electric materials, ceramic materials, and catalysts. The metallic oxide particles can be oxide particles or hydroxide particles of one kind of metal, or a composite oxide of plural kinds of metals. Specifically, it is possible to use particles of alumina, magnesium oxide, manganese dioxide, zinc oxide, zirconia, tin oxide, antimony oxide, barium titanate, magnesium titanate, calcium titanate, magnesium hydroxide, aluminum hydroxide, and calcium hydroxide. The insulating particles are expected to make the paste composition appropriately easy to cut, and therefore preferably have high specific gravity. Therefore, among the aforementioned insulating particles, the components having a density exceeding 4 g/cm³ are particularly preferable for effectively achieving the objects of the present invention, which components are alumina, magnesium oxide, zinc oxide, zirconia, tin oxide, antimony oxide, barium titanate, magnesium titanate, and calcium titanate. Furthermore, examples of insulating particles are inorganic porous particles having micropores or mesopores in the structure, such as zeolite or mesoporous silica. The insulating particles can also be made of silica or titania, with hydrophobic treated surfaces. By performing hydrophobic treatment on the particle surfaces, the particle surfaces can be covered with materials other than silica or titania, so that the thickening effect is lower than that of the insulating filling material particles, and objects of the present invention can be achieved. The method of performing hydrophobic treatment can be a conventionally known method. By making the insulating particles contact a hydrophobizing agent such as alkyl alkoxysilane, alkyl disilazane, a surface-active agent, and silicone oil, the surfaces of the particles can be easily hydrophobic treated. Effects of the hydrophobic process can be confirmed by measuring the contact angles.

Furthermore, a combination of the insulating particles and the insulating filling material particles is selected such that the ratio of the insulating particles is higher, so that the object of the present invention can be effectively achieved.

A conventionally known resin can be used in the paste composition according to an embodiment of the present invention, such as solvent soluble resin, ultraviolet curing resin, and heat curing resin. Specific examples are polyvinyl alcohol resin, polyvinyl acetal resin, polyvinyl butyral resin, ethyl cellulose resin, methyl cellulose resin, polyethylene, polystyrene, acrylic resin, phenolic resin, and epoxy resin. However, for a paste composition used for screen printing, it is preferable to select a solvent soluble resin with which the viscosity can be easily adjusted, or an ultraviolet curing resin with which pattern variations caused by curing are less likely to occur.

When a solvent is included in the paste composition according to an embodiment of the present invention, the resin is preferably dissolved in the solvent to obtain a homogeneous solution.
Furthermore, a high boiling point solvent is preferably selected, so that it does not dry during the printing operation. Specifically, the solvent is preferably selected from alcohols, ketones, glycol ether, esters, and aromatic series. The solvent can be one kind of component or a mixture of plural kinds of components.

The stability and the flexibility of the paste composition according to an embodiment of the present invention can be improved by adding a dispersing agent, a plasticizer, or a viscosity adjusting agent, according to need, in addition to the above-described components.

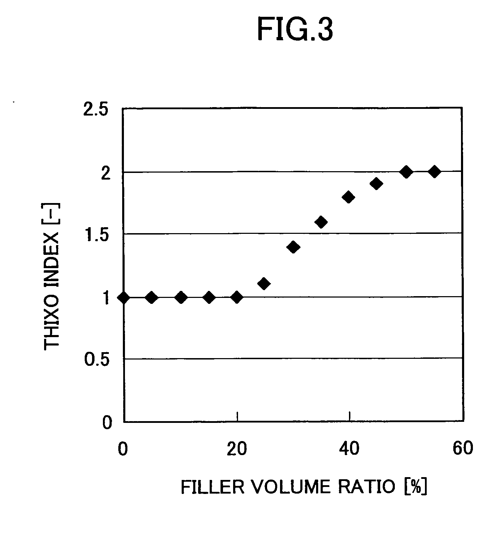

The volume of the filler in the paste composition according to an embodiment of the present invention is preferably more than or equal to one third of the volume of the resin component through less than three times the volume of the resin component. In the paste composition, the filler has a function of exhibiting the thixotropic property, and is therefore required to have a certain volume with respect to the resin component. Experiment results on the relationship between the volume ratio of the filler and the thixotropic property are shown in FIG. 3. Several variations of paste compositions including the solvent, the resin, and the filler were prepared, so that the volume ratio of the filler with respect to the solid component (resin and filler) was different for each variation. The thixo index was evaluated for each of the paste compositions. The thixo index was obtained as a ratio of viscosity with the use of a rotary viscometer, when the rotational frequency was 10 rpm and 50 rpm. When the volume ratio of the filler was low, the thixo index was 1.0, which means that the viscosity is constant regardless of the rotational frequency, and the thixotropic property has not appeared. When the volume ratio of the filler exceeded 20%, the thixo index started changing. It can be observed that the thixo index starts increasing as the volume ration starts increasing. Thus, the amount of filler to be added needs to be more than 20% of the total amount of the resin and the filler. In other words, the filler volume is to be more than or equal to one third of the resin volume. If the filler volume was more than or equal to half of the resin volume, the thixo index would be more than or equal to 1.5, thereby reliably exhibiting the thixotropic property.

Conversely, if the amount of filler was too large, air gaps may be formed after the printing operation, or the film may have poor flexibility. Generally, the filling factor of spheres in a microscopic filling structure is 74%. Thus, assuming that the filler particles are spheres of the same size, when the volume ratio of the filler with respect to the solid component exceeds 74%, theoretically, air gaps will be formed. In such an air gap, neither the filler nor the resin is present. When a paste is prepared in practical circumstances, the filler will not only include spherical particles, and there will be a particle diameter distribution. Therefore, the filling factor may well exceed 74%. However, in order to provide a paste and an insulating film having superior uniformity, precision, and flexibility, the filler volume ratio is preferably less than 74%, i.e., the filler volume is preferably less than three times the resin volume, more preferably less than two times the resin volume.

The volume of the filler and the resin is calculated from the mass and the true density of the filler and the resin. The ratio of the volume of the filler and the volume of the resin is obtained based on the volumes of the filler and the resin before they are mixed together.

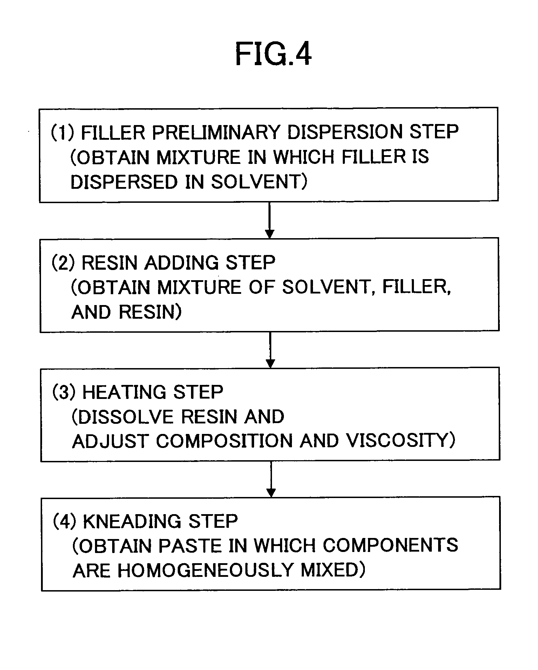

The manufacturing method of the paste composition according to an embodiment of the present invention is described below with reference to FIG. 4.
(1) In a filler preliminary dispersion step, a filler including insulating filling material particles and insulating particles is dispersed in a solvent, to prepare a fluid dispersion including the solvent and the filler. Specifically, the filler is added to the solvent, and this mixture is put in a dispersing device, to dissociate the agglomerate filler and disperse it in the solvent. The dispersing device can be appropriately selected according to the amount of the dispersion medium and the particle sizes of the filler, from an impeller dispersing device, a homogenizer, a planetary ball mill, a rotary and revolutionary mixer, and a bead mill. Among these, a bead mill is preferably used, because it can be used for a relatively wide range of viscosity levels, and submicron filler particles can be dispersed. When a dispersing agent is used, the dispersing agent is added to the liquid mixture of the solvent and the filler, before the liquid mixture is put in the dispersing device. Furthermore, some of the resin can be added to the mixture of the solvent and the filler before performing the dispersion process. Accordingly, a part of or the entire surface of the filler particles can be coated with a resin component, to prevent the filler from being agglomerated when the mixture is subsequently turned into a paste.
(2) In a resin adding step, resin is added to the fluid dispersion and mixed together with the fluid dispersion. The resin is preferably added by small portions at a time while stirring the fluid dispersion. If the resin is a powder, care is to be taken when adding/mixing the powder resin so that the resin material does not form lumps immediately after being added. A stirring device such as a homogenizer, a three-roll mill, a rotary and revolutionary mixer, and a grinding machine can be used for the mixing process. Furthermore, when a plasticizer and a viscosity adjusting agent are to be used, these agents are preferably added to the fluid dispersion by small portions at a time at this step.
(3) In a heating step, the fluid dispersion to which resin has been added is heated, so that the resin is completely dissolved or dispersed in the solvent. Furthermore, any unnecessary solvent components are evaporated to adjust the fluid dispersion to a desired composition/viscosity. This heating step is performed according to need, and can be performed at the same time as the step of adding the resin.
(4) In a kneading step, which is the final step, the fluid dispersion whose composition/viscosity has been adjusted is kneaded with a device such as a three-roll mill. Accordingly, the paste composition according to an embodiment of the present invention is achieved, in which the components are homogeneously mixed.

The insulating film according to an embodiment of the present invention can be formed by using the above described paste composition according to an embodiment of the present invention, so that a pattern including microscopic through holes are formed in the insulating film by a screen printing method. Similarly to the paste composition according to an embodiment of the present invention, in the insulating film according to an embodiment of the present invention, the average particle diameter of the insulating filling material particles is preferably smaller than that of the insulating particles. Specifically, the average particle diameter of the insulating filling material particles is preferably more than or equal to 20 nm and less than or equal to 1 µm, more preferably more than or equal to 40 nm and less than or equal to 0.8 µm. Furthermore, the maximum particle diameter in the filler is preferably defined based on the relationship with the insulating film, as described for the paste composition according to an embodiment of the present invention. Furthermore, the insulating particles in the insulating film according to an embodiment of the present invention preferably includes at least one kind of component selected from alumina, magnesium oxide, manganese dioxide, zinc oxide, zirconia, tin oxide, antimony oxide, barium titanate, magnesium titanate, calcium titanate, magnesium hydroxide, aluminium hydroxide, and calcium hydroxide. The volume of the filler is preferably more than or equal to one third of the volume of the resin component through less than three times the volume of the resin component, more preferably more than or equal to one half of the volume of the resin component through less than two times the volume of the resin component. The volume of the insulating filling material particles is preferably more than or equal to 20% and less than or equal to 80% of the entire volume of the filler, more preferably more than or equal to 40% and less than or equal to 70% of the entire volume of the filler. The insulating film according to an embodiment of the present invention preferably has the above configuration, due to the same reasons described for the paste composition according to an embodiment of the present invention.

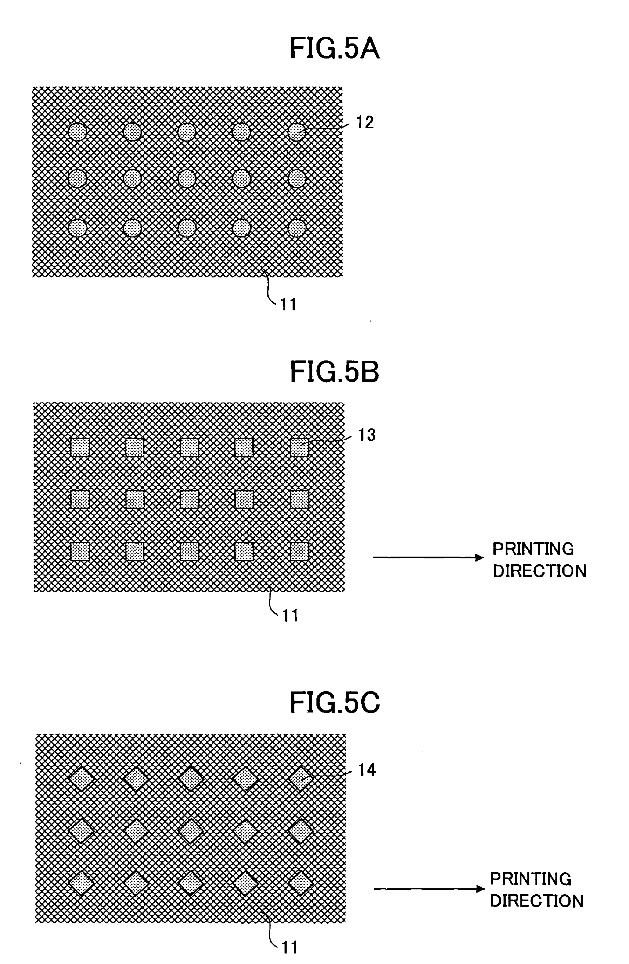

The paste composition according to an embodiment of the present invention includes, as the filler, at least insulating particles and insulating filling material particles including silica and/or titania particles. The volume of the insulating filling material particles is more than or equal to 20% of the total volume of the filler and less than or equal to 80% of the total volume of the filler. Therefore, fine patterns can be formed, which has been difficult with conventional pastes. For example, by using screen printing plates having through hole patterns as shown in FIGS. 5A through 5C with the paste composition according to an embodiment of the present invention, it is possible to form the insulating film according to an embodiment of the present invention having plural microscopic through holes. In FIGS. 5A through 5C, the hatching portions correspond to a screen mesh 11 where printing is performed, and the circular or square portions correspond to through holes 12, 13, and 14, coated with an emulsion. Generally, through holes are provided as regularly aligned patterns.

The shapes of through holes are not particularly limited. However, if the through holes were polygonal, the through holes are preferably arranged in a pattern as shown in FIG. 5C in which none of the sides of the through holes are orthogonal to the printing direction, instead of a pattern as shown in FIG. 5B in which the through holes have sides that are orthogonal to the printing direction. This is because if sides of the through holes are orthogonal to the printing direction, when the squeegee comes to the through holes (where the emulsion is applied), the flow of the paste will be stopped at the through holes (emulsion). Thus, due to the force of the squeegee, the paste is likely to slip under the emulsion and cause smudges. To prevent this, the through holes are preferably arranged in a pattern in which none of the sides of the through holes are orthogonal to the printing direction.

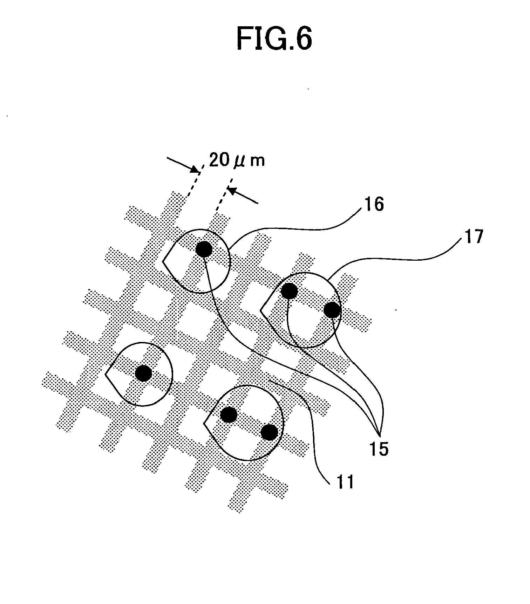

Furthermore, in order to form an insulating film with through holes having good properties, the size of each through hole is preferably less than 300 µm if the through hole is a circle, and preferably fits in an area of 300 µm² if the through hole is a square. Moreover, the minimum size of the through holes is limited by the sizes of the mesh openings of the screen printing plate. Thus, theoretically, as the mesh openings become finer and increasingly high-density, it will be possible to form smaller through holes. In the finest mesh for currently-available screen printing plates, wires having a diameter of approximately 10 µm are weaved at a density of 840 wires per inch. As shown in FIG. 6, each mesh opening is approximately 20 µm wide. Generally, when the through hole pattern for the emulsion is supported in the mesh 11, each through hole is to include at least two intersections 15 in the mesh. As shown in FIG. 6, a through hole 16 having a diameter of 40 µm includes only one of the intersections 15 in the mesh, and therefore the contacting area of the mesh 11 and the emulsion is small. As a result, the emulsion may fall off during the printing operation. A through hole 17 having a diameter of 50 µm includes approximately two or more intersections 15 in the mesh. Accordingly, the size of each through hole in the insulating film according to an embodiment of the present invention is more than or equal to 50 µm, so that through holes can be stably formed even in screen printing for a large area.

From above the insulating film having through holes formed in the above-described manner, a conductive paste is applied into the through holes by a screen printing method. Accordingly, the insides of the through holes become via holes with conductive layers, thereby forming an insulating film with microscopic via holes.

The insulating film with via holes and plural electrodes are laminated at predetermined arrangements, and electrodes above and under the insulating film are electrically connected via the via holes. Accordingly, compared to the conventional technology, the number of manufacturing processes can be significantly reduced, and a multilayer interconnection structure having an increasingly microscopic structure can be provided. In order to electrically connect the electrodes above and under the insulating film, it is indispensable to provide conductive layers inside the through holes. A particularly simple method is to provide the top electrodes and provide the conductive materials in the through holes by the screen printing method. This method of forming via holes is preferable because the same device used for screen printing for electrodes can also be used for the via holes, and the screen printing for the electrodes and the via holes can be performed simultaneously, thereby simplifying the processes.

By fabricating this multilayer interconnection structure on a substrate, a printed-circuit board can be made. By using the paste composition according to an embodiment of the present invention and by performing the screen printing method to form an interlayer insulating film in the multilayer interconnection structure, the resultant printed-circuit board will have the following advantages over a conventional printed-circuit board. That is, the printed-circuit board will have superior throughput, and the printed-circuit board can be manufactured by a low-temperature process, and therefore glass substrates are obviously applicable, as well as plastic film substrates such as a polycarbonate substrate or a polyether sulfone substrate. Furthermore, by applying the resultant printed-circuit board to an image display device, the image display device can be made thin, light-weight, and can be manufactured at low-cost.

### [Practical Examples]

### (Practical Examples 1 through 4, Comparative examples 1 through 3)

The following materials were prepared for the paste composition: ethyl cellulose resin; ethylene glycol monobutyl ether; α-terpineol; spherical alumina filler (manufactured by Denki Kagaku Kogyo Co., Ltd., average particle diameter 0.2 µm); and spherical silica filler (manufactured by Denki Kagaku Kogyo Co., Ltd., average particle diameter 0.04 µm).

A mixed solvent was obtained by mixing together the ethylene glycol monobutyl ether and the α-terpineol, at a weight ratio of 1:1. The spherical alumina filler and the spherical silica filler were added to this mixed solvent. Seven types of such mixtures were prepared, with different mixture ratios of filler. In each of these seven types of mixtures, the volume of the spherical silica filler with respect to the total volume of the filler was 20% (practical example 1), 40% (practical example 2), 60% (practical example 3), 80% (practical example 4), 10% (comparative example 1), 90% (comparative example 2), and 100% (comparative example 3).

Each mixture was set in a paint shaker (three-dimensional oscillating type bead mill) with zirconia beads, and underwent a grinding-dispersing process for three hours at a frequency of 60 Hz. Then, the beads were separated from the solvent, to obtain seven types of fluid dispersions in which the filler are ground and dispersed as primarily particles.

Next, the ethyl cellulose resin was added to each fluid dispersion, such that the volume of the resin is equal to the volume of the filler, and the fluid dispersion was heated by an oven at 60 °C to dissolve the resin. Subsequently, the fluid dispersion was kneaded with a three-roll mill, to obtain paste composition precursors 1 through 7, in which the materials are homogeneously dispersed (practical examples 1 through 4 correspond to paste composition precursors 1 through 4, and comparative examples 1 through 3 correspond to paste composition precursors 5 through 7, respectively). Each of the paste composition precursors 1 through 7 was further kneaded according to need, while adding a solvent or evaporating the solvent, to be adjusted to a viscosity of 300 Pa·s (practical examples 1 through 4 correspond to paste composition precursors 1 through 4, and comparative examples 1 through 3 correspond to paste composition precursors 5 through 7, respectively).

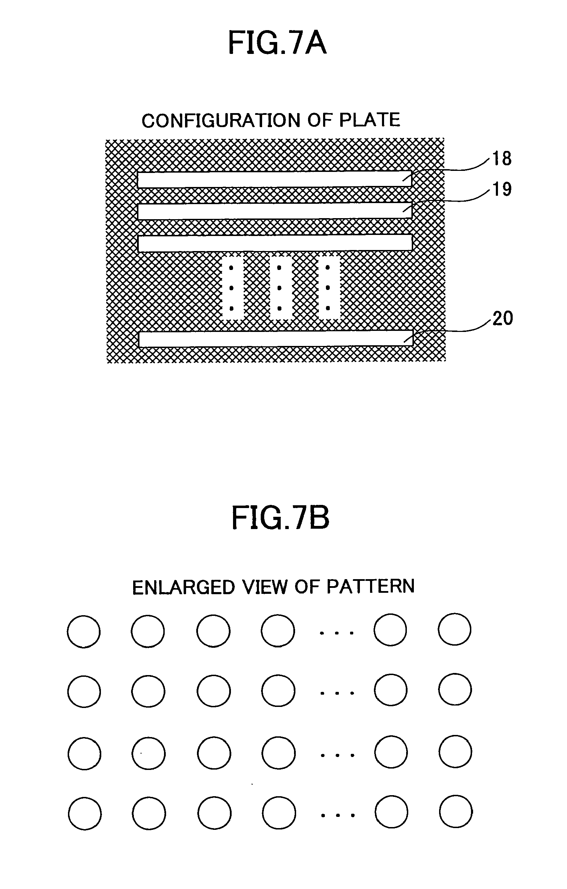

A mesh made with wires having a diameter of 18 µm having a mesh opening ratio of approximately 40% was used to prepare a screen printing plate (also simply referred to as "plate") with through hole patterns as shown in FIGS. 7A and 7B. As shown in FIG. 7A, in this screen printing plate, through hole patterns (denoted by 18 through 20 in FIG. 7A) with circular through holes are provided at seven locations in the printing surface. The through holes had different diameters ranging from 350 µm through 50 µm, in increments of 50 µm. For example, the through hole pattern 18 includes through holes with diameters of 350 µm, the through hole pattern 19 includes through holes with diameters of 300 µm, and the through hole pattern 20 includes through holes with diameters of 50 µm. As shown in FIG. 7B, each pattern included four rows of through holes, with 250 through holes arranged at a pitch of 500 µm in each row, thus including a total of 1000 through holes. Each of the adjusted paste compositions 1 through 7 was used as ink to be printed on a washed glass substrate with the use of the above screen printing plate. Then, the substrate was baked in an oven at 110 °C for 30 minutes to dry the solvent. Accordingly, insulating films 1 through 7 were formed, having the through hole patterns according to the above screen printing plate.

For each of the insulating films 1 through 7, the through hole patterns including through holes of different sizes were observed with a microscope. The numbers of through holes having different diameters that were formed without being filled with ink are shown in Table 1. In the insulating films 1 through 4 corresponding to practical example 1 through 4, with regard to through holes having diameters of 350 µm through 200 µm, more than 90% were visible. Particularly in the insulating film 3 (practical example 3), in which the volume of the spherical silica filler was 60% of the total volume of the filler, substantially 100% of the through holes of more than or equal to 100 µm were visible, and 76% of the through holes having diameters of 50 µm were visible. Thus, it was confirmed that the insulating film 3 had the most stable printing properties. Furthermore, the insulating film 2 (practical example 2), in which the volume of the spherical silica filler was 40% of the total volume of the filler, exhibited the second most stable printing properties next to the insulating film 3 (practical example 3). Meanwhile, in comparative example 1 in which the volume ratio of the spherical silica filler (insulating filling material particles) is 10 vol%, comparative example 2 in which the volume ratio of the spherical silica filler (insulating filling material particles) is 90 vol%, and comparative example 3 in which the volume ratio of the spherical silica filler (insulating filling material particles) is 100 vol%, through holes having diameters of more than or equal to 300 µm were formed; however, it was observed that through holes having diameters of less than or equal to 250 µm had disappeared in the patterns. Furthermore, in comparative example 1, mesh traces were observed, and therefore the film had an inferior flatness compared to those of the other examples.

**(Table 1)**

| | INSULATING FILM | DIAMETER OF THROUGH HOLE (µm) | | | | | | | MESH TRACES |
|---|---|---|---|---|---|---|---|---|---|
| | | 350 | 300 | 250 | 200 | 150 | 100 | 50 | |
| PRACTICAL EXAMPLE 1 | 1 | 1000 | 1000 | 1000 | 900 | 750 | 560 | 220 | NONE |
| PRACTICAL EXAMPLE 2 | 2 | 1000 | 1000 | 1000 | 1000 | 820 | 690 | 310 | NONE |
| PRACTICAL EXAMPLE 3 | 3 | 1000 | 1000 | 1000 | 1000 | 1000 | 995 | 760 | NONE |
| PRACTICAL EXAMPLE 4 | 4 | 1000 | 1000 | 1000 | 915 | 660 | 420 | 150 | NONE |
| COMPARATIVE EXAMPLE 1 | 5 | 1000 | 1000 | 745 | 550 | 180 | 0 | 0 | PRESENT |
| COMPARATIVE EXAMPLE 2 | 6 | 1000 | 1000 | 970 | 480 | 245 | 160 | 0 | NONE |
| COMPARATIVE EXAMPLE 3 | 7 | 1000 | 1000 | 550 | 290 | 40 | 0 | 0 | NONE |

### (Practical Examples 5 through 9)

The following materials were prepared for the paste composition: polyvinyl butyral resin (three types of S-LEC manufactured by Sekisui Chemical Co., Ltd.: low polymerization degree product (approximately 300 polymerization degrees), middle polymerization degree product (approximately 600 polymerization degrees), and high polymerization degree product (approximately 1700 polymerization degrees)); ethylene glycol monohexyl ether; a barium titanate filler (manufactured by Sakai Chemical Industry Co.,Ltd., average particle diameter 0.15 µm); and a spherical silica filler (manufactured by Denki Kagaku Kogyo Co., Ltd., average particle diameter 0.04 µm).

Two types of filler, the barium titanate filler and the spherical silica filler were added to a solvent at a volume ratio of 40% for the barium titanate filler and 60% for the spherical silica filler. The solvent including the filler was set in a paint shaker (three-dimensional oscillating type bead mill) with zirconia beads, and underwent a grinding-dispersing process for three hours at a frequency of 60 Hz. Then, the beads were separated from the solvent, to obtain a fluid dispersion in which the filler are ground and dispersed as primarily particles.

Next, the fluid dispersion was divided into three fluid dispersions (practical example 5 through 9). The low polymerization degree resin was added for practical examples 5 and 6, the middle polymerization degree resin was added for practical example 7, and the high polymerization degree resin was added for practical examples 8 and 9. In these practical examples, the amount of the resin was adjusted so that the volume of the filler was three-tenths, one half, one time, two times, and three times the volume of resin component for each of the practical examples 5 through 9, respectively. Subsequently, each fluid dispersion was heated by an oven at 80 °C to dissolve the resin. Then, each fluid dispersion was kneaded with a three-roll mill, to obtain five paste composition precursors 8 through 12, in which the materials are homogeneously dispersed. Each of the paste composition precursors 8 through 12 was further kneaded according to need, while adding a solvent or evaporating the solvent, to be adjusted to a viscosity of 300 Pa·s, thereby obtaining paste compositions 8 through 12.

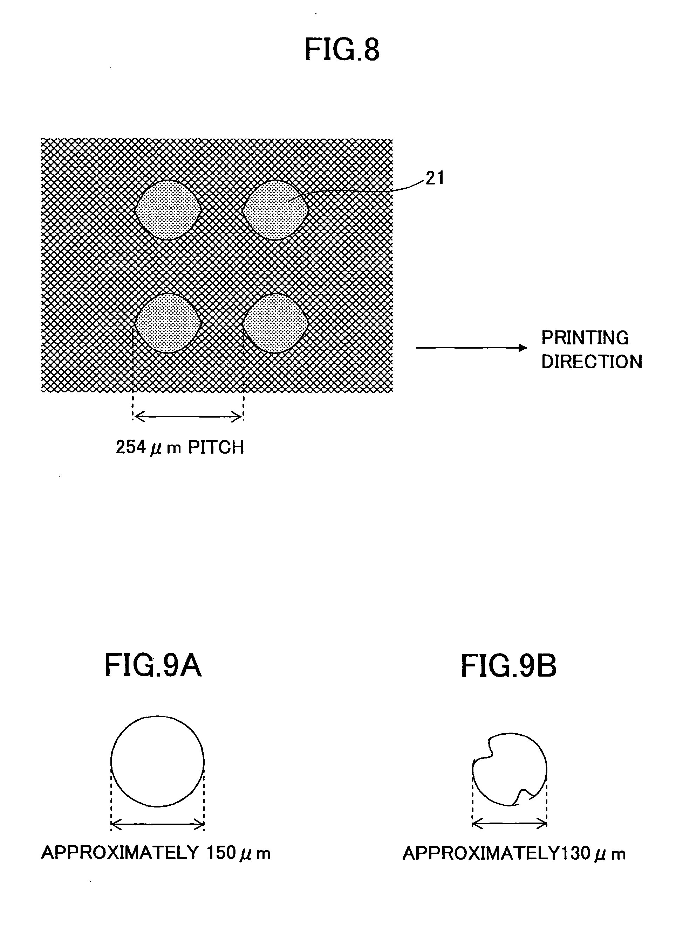

A mesh made with wires having a diameter of 18 µm having a mesh opening ratio of approximately 40% was used to prepare a screen printing plate with through hole patterns as shown in FIGS. 7A and 7B. As shown in FIG. 8, in the printing surface of this screen printing plate, patterns with leaf-shaped through holes 21 (each being a tree-leaf shape of 180 µm x 180 µm with apexes on both ends along the printing direction) that each fit in an area of 180 µm², are provided at a pitch of 254 µm. Each of the adjusted paste compositions 8 through 12 was used as ink to be printed on a washed plastic substrate with the use of the above screen printing plate. Then, the substrate was baked in an oven at 110 °C for 30 minutes to dry the solvent. Accordingly, five insulating films 8 through 12 were formed.

Upon observing the through hole patterns formed on the insulating films 8 through 12 with a microscope, it was confirmed that the microscopic through holes were formed without any deficiencies, with the use of any of the paste compositions 8 through 12. Each of the through holes formed in the insulating film 8 was substantially circular with different diameters ranging from approximately 80 µm through 130 µm. As shown in FIG. 9A, the through holes formed in the insulating films 9 through 12 were uniform and substantially circular, each having a diameter of approximately 150 µm. The insulating films 8 through 12 were cut with a microtome, and the sectional surfaces were observed with a scanning electron microscope (SEM). In the insulating films 8 through 11, air gaps were observed, in which neither the resin nor the filler were present. The air gap rate was less than 1% in the insulating films 8 and 9, approximately 2% in the insulating film 10, and approximately 5% in the insulating film 11. In parts of the insulating film 12, microscopic cracks were observed.

### (Practical example 10)

The following materials were prepared for the paste composition: polyvinyl butyral resin (S-LEC manufactured by Sekisui Chemical Co., Ltd.: middle polymerization degree product (approximately 600 polymerization degrees)); ethylene glycol monohexyl ether; a barium titanate filler (manufactured by Sakai Chemical Industry Co.,Ltd., average particle diameter 0.15 µm); and a spherical silica filler (manufactured by Denki Kagaku Kogyo Co., Ltd., average particle diameter 0.2 µm).

Two types of filler, the barium titanate filler and the spherical silica filler were added to a solvent at a volume ratio of 40% for the barium titanate filler and 60% for the spherical silica filler. Subsequently, a paste composition 13 was prepared in the same manner as that for the paste composition 10 of practical example 7. The paste composition 13 was used as ink to be printed on a washed plastic substrate with the use of the same screen printing plate as that used for practical example 7. Then, the substrate was dried to form an insulating film 13.

Upon observing the through hole patterns formed on the insulating film 13 with a microscope, it was confirmed that the microscopic through holes were formed without any deficiencies. As shown in FIG. 9B, each of the formed through holes were substantially circular with a diameter of approximately 130 µm, and horn-shaped protrusions and recessions were ubiquitously formed, which were presumably formed because the paste composition became stringy during the printing operation.

### (Practical example 11)

The following materials were prepared for the paste composition: polyvinyl butyral resin (S-LEC manufactured by Sekisui Chemical Co., Ltd.: low polymerization degree product (approximately 300 polymerization degrees)); ethylene glycol monohexyl ether; a spherical alumina filler (manufactured by Denki Kagaku Kogyo Co., Ltd., average particle diameter 0.2 µm); and a spherical silica filler (manufactured by Denki Kagaku Kogyo Co., Ltd., average particle diameter 0.04 µm).

Two types of filler, the spherical alumina filler and the spherical silica filler, were added to the ethylene glycol monohexyl ether at a volume ratio of 40% for the spherical alumina filler and 60% for the spherical silica filler. This was set in a paint shaker (three-dimensional oscillating type bead mill) with zirconia beads, and underwent a grinding-dispersing process for three hours at a frequency of 60 Hz. Then, the beads were separated to obtain a fluid dispersion in which the filler are ground and dispersed as primarily particles.

Next, the polyvinyl butyral resin was added to the fluid dispersion such that the filler volume is four-fifths of that of the resin. The fluid dispersion was heated by an oven at 80 °C to dissolve the resin. Subsequently, the fluid dispersion was kneaded with a three-roll mill while adjusting the amount solvent, to obtain a paste composition 14 having a viscosity of 350 Pa·s.

On a polycarbonate substrate, an Al film was formed by a sputtering method, and gate electrodes were formed by a photolithography etching method. On top of these, a silica film was formed by a plasma CVD method, thereby forming a gate insulating film. Furthermore, an Al film was formed by a sputtering method, and source electrodes and drain electrodes were formed by a photolithography etching method. Next, an organic semiconductor material expressed by the following structural formula was dissolved in xylene to obtain ink. This ink was used to form an organic semiconductor layer at a predetermined position by ink-jet printing. This was dried to obtain an organic transistor. The organic transistor had a channel length of 10 µm and a channel width of 200 µm.

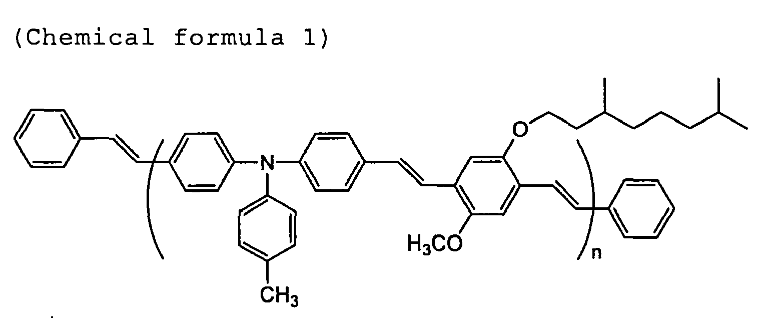

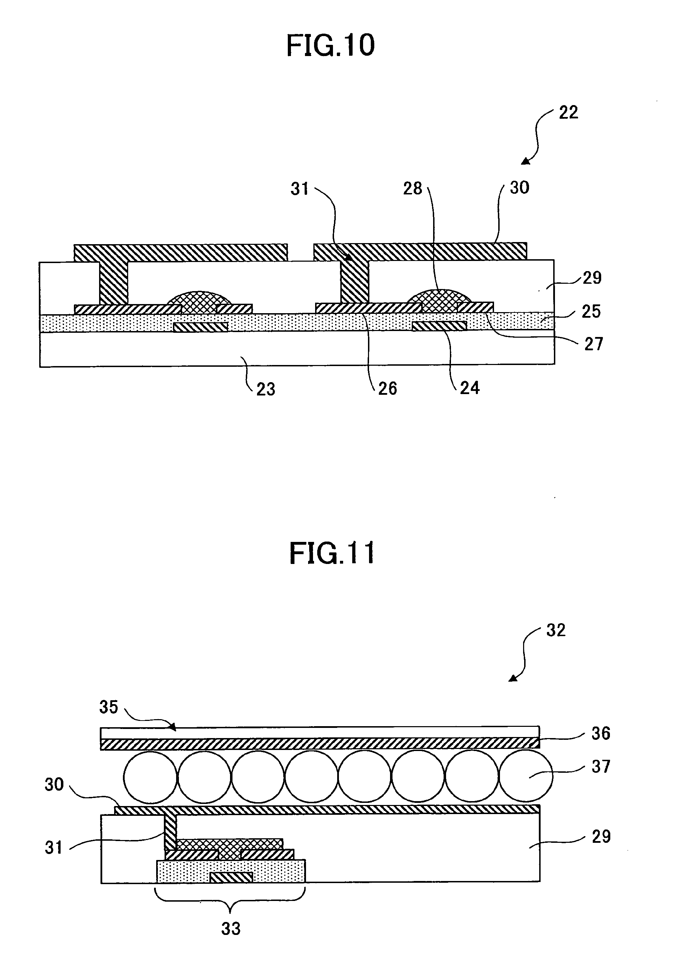

The same screen printing plate as that used in practical example 7 was used to screen-print the paste composition 14 on the organic transistor. Specifically, as shown in FIG. 10, the paste composition 10 was positioned so that each through hole corresponding to a via hole 31 is formed on a source electrode 26. Then, the paste composition 10 was dried. On top of this, a silver paste including silver particles, acrylic resin, and a solvent was used to screen-print an upper electrode 30 that can be in electric conduction with the organic transistor on the bottom layer. The upper electrode 30 was then dried. Accordingly, an active matrix substrate was formed, including transistor devices provided in a lattice. This active matrix substrate is the printed-circuit board having an multilayer interconnection structure 22 according to an embodiment of the present invention. FIG. 10 illustrates part of this multilayer interconnection structure 22, showing structures of two transistor devices. In FIG. 10, 23 denotes a substrate, 24 denotes a gate electrode, 25 denotes a gate insulating film, 27 denotes a drain electrode, 28 denotes a semiconductor, and 29 denotes an interlayer insulating film.

Next, 20 parts by weight of titanium oxide, one part by weight of modified silicone methacrylic acid copolymer containing a methacryl group, two parts by weight of silicone polymer grafted carbon black MX3-GRX-001 (manufactured by Nippon Shokubai Co., Ltd.), and 77 parts by weight of silicone oil KF96L-1cs (manufactured by Shin-Etsu Chemical Co., Ltd.) were mixed together, and were then dispersed for one hour with ultrasonic waves, thereby preparing a fluid dispersion of black and white particles. Furthermore, a complex coacervation process was performed with the use of gelatine and gum, to turn the fluid dispersion of black and white particles into microcapsules. The average particle diameter of the microcapsules was approximately 60 µm. Next, the microcapsules were dispersed in an urethane resin solution to obtain a fluid dispersion. This fluid dispersion was spread onto a film substrate with a transparent electrode film by performing a wire braider method, to form a homogeneous microcapsule sheet, thus achieving an electronic portal imaging device.

The electronic portal imaging device was joined to the active matrix substrate, and an image display device 32 shown in FIG. 11 was formed. The image display device exhibited good displaying properties. In FIG. 11, 33 denotes a transistor device, 35 denotes a supporting substrate, 36 denotes a transparent electrode, and 37 denotes electrophoretic microcapsules.

An aspect in accordance with the present invention provides a paste composition including a filler including insulating filling material particles including at least one of silica and titania, and insulating particles including at least one of silica and titania whose surfaces have been hydrophobic treated, or insulating particles having at least their surfaces including a material other than silica or titania; and a resin, wherein a volume of the insulating filling material particles is more than or equal to 20% of a total volume of the filler and less than or equal to 80% of the total volume of the filler.

Additionally, in the paste composition, an average particle diameter of the insulating filling material particles is smaller than an average particle diameter of the insulating particles.

Additionally, in the paste composition, the average particle diameter of the insulating filling material particles is more than or equal to 20 nm and less than or equal to 1 µm.

Additionally, in the paste composition, the insulating particles include at least one kind of component selected from alumina, magnesium oxide, manganese dioxide, zinc oxide, zirconia, tin oxide, antimony oxide, barium titanate, magnesium titanate, calcium titanate, magnesium hydroxide, aluminium hydroxide, and calcium hydroxide.

Additionally, in the paste composition, a volume of the filler is more than or equal to one third of a volume of the resin and less than three times the volume of the resin.

Another aspect in accordance with the present invention provides an insulating film including a filler including insulating filling material particles including at least one of silica and titania, and insulating particles including at least one of silica and titania whose surfaces have been hydrophobic treated, or insulating particles having at least their surfaces including a material other than silica or titania; and a resin, wherein a volume of the insulating filling material particles is more than or equal to 20% of a total volume of the filler and less than or equal to 80% of the total volume of the filler.

Additionally, in the insulating film, an average particle diameter of the insulating filling material particles is smaller than an average particle diameter of the insulating particles.

Additionally, in the insulating film, the average particle diameter of the insulating filling material particles is more than or equal to 20 nm and less than or equal to 1 µm.

Additionally, in the insulating film, the insulating particles include at least one kind of component selected from alumina, magnesium oxide, manganese dioxide, zinc oxide, zirconia, tin oxide, antimony oxide, barium titanate, magnesium titanate, calcium titanate, magnesium hydroxide, aluminium hydroxide, and calcium hydroxide.

Additionally, in the insulating film, a volume of the filler is more than or equal to one third of a volume of the resin and less than three times the volume of the resin.

Additionally, the insulating film further includes via holes.

Another aspect in accordance with the present invention provides a multilayer interconnection structure in which electrodes are formed via the above insulating film.

Another aspect in accordance with the present invention provides a printed-circuit board including the above multilayer interconnection structure.

Another aspect in accordance with the present invention provides an image display device including the printed-circuit board.

Another aspect in accordance with the present invention provides a method of manufacturing a paste composition, the method including a step of dispersing a filler in a solvent to prepare a fluid dispersion, the filler including insulating filling material particles including at least one of silica and titania, and insulating particles including at least one of silica and titania whose surfaces have been hydrophobic treated or insulating particles having at least their surfaces including a material other than silica or titania; a step of preparing a resin liquid mixture by adding a resin to the fluid dispersion; a step of dissolving the resin by heating the resin liquid mixture to prepare a resin solution; and a step of preparing a homogeneous paste composition by kneading the resin solution.

## Claims

1. A paste composition comprising:
a filler comprising
insulating filling material particles comprising at least one of silica and titania, and
insulating particles comprising at least one of silica and titania whose surfaces have been hydrophobic treated, or insulating particles having at least their surfaces comprising a material other than silica or titania; and
a resin, wherein:
a volume of the insulating filling material particles is more than or equal to 20% of a total volume of the filler and less than or equal to 80% of the total volume of the filler.

2. The paste composition according to claim 1, wherein:
an average particle diameter of the insulating filling material particles is smaller than an average particle diameter of the insulating particles.

3. The paste composition according to claim 1 or 2, wherein:
the average particle diameter of the insulating filling material particles is more than or equal to 20 nm and less than or equal to 1 µm.

4. The paste composition according to any one of claims 1 through 3, wherein:
the insulating particles comprise at least one kind of component selected from alumina, magnesium oxide, manganese dioxide, zinc oxide, zirconia, tin oxide, antimony oxide, barium titanate, magnesium titanate, calcium titanate, magnesium hydroxide, aluminium hydroxide, and calcium hydroxide.

5. The paste composition according to any one of claims 1 through 4, wherein:
a volume of the filler is more than or equal to one third of a volume of the resin and less than three times the volume of the resin.

6. An insulating film comprising:
a filler comprising
insulating filling material particles comprising at least one of silica and titania, and
insulating particles comprising at least one of silica and titania whose surfaces have been hydrophobic treated, or insulating particles having at least their surfaces comprising a material other than silica or titania; and
a resin, wherein:
a volume of the insulating filling material particles is more than or equal to 20% of a total volume of the filler and less than or equal to 80% of the total volume of the filler.

7. The insulating film according to claim 6, wherein:
an average particle diameter of the insulating filling material particles is smaller than an average particle diameter of the insulating particles.

8. The insulating film according to claim 6 or 7, wherein:
the average particle diameter of the insulating filling material particles is more than or equal to 20 nm and less than or equal to 1 µm.

9. The insulating film according to any one of claims 6 through 8, wherein:
the insulating particles comprise at least one kind of component selected from alumina, magnesium oxide, manganese dioxide, zinc oxide, zirconia, tin oxide, antimony oxide, barium titanate, magnesium titanate, calcium titanate, magnesium hydroxide, aluminium hydroxide, and calcium hydroxide.

10. The insulating film according to any one of claims 6 through 9, wherein:
a volume of the filler is more than or equal to one third of a volume of the resin and less than three times the volume of the resin.

11. The insulating film according to any one of claims 6 through 10, further comprising:
via holes.

12. A multilayer interconnection structure in which electrodes are formed via the insulating film according to claim 11.

13. A printed-circuit board comprising the multilayer interconnection structure according to claim 12.

14. An image display device comprising the printed-circuit board according to claim 13.

15. A method of manufacturing a paste composition, the method comprising:
a step of dispersing a filler in a solvent to prepare a fluid dispersion, the filler comprising insulating filling material particles comprising at least one of silica and titania, and insulating particles comprising at least one of silica and titania whose surfaces have been hydrophobic treated or insulating particles having at least their surfaces comprising a material other than silica or titania;
a step of preparing a resin liquid mixture by adding a resin to the fluid dispersion;
a step of dissolving the resin by heating the resin liquid mixture to prepare a resin solution; and
a step of preparing a homogeneous paste composition by kneading the resin solution.
